# FASCICULE DE BREVET EUROPEEN

(11) **EP 0 499 523 B1**
(45) Date de publication et mention de la délivrance du brevet: **30.08.1995**
(21) Numéro de dépôt: 92400343.7
(22) Date de dépôt: 11.02.1992
(51) Int. Cl.: C23C 16/44, C03C 17/00

(54) **Buse à talon aval surelevé, pour déposer une couche de revêtement sur un ruban de verre, par pyrolyse d'un mélange gazeux**
Düse mit angehobenem stromabwärts liegendem Absatz zur Beschichtung eines Glasbandes durch Pyrolyse eines Gasgemisches
Nozzle with raised downstream toe for deposition of a coating on a sheet of glass by pyrolysis of a gas mixture

(30) Priorité: 13.02.1991 FR 9101683
(43) Date de publication de la demande: 19.08.1992
(73) Titulaire: SAINT-GOBAIN VITRAGE, 92400 Courbevoie (FR)
(72) Inventeur: Sauvinet, Vincent, F-93200 Saint-Denis (FR); Oudard, Jean-François, F-60310 Thiescourt (FR)
(74) Mandataire: Muller, René

(56) Documents cités:
- WO-A-90/02826
- FR-A- 2 314 152

## Description

La présente invention concerne une buse équipant un appareil pour la formation, sur un ruban de verre chaud, d'une couche de revêtement obtenue à partir de gaz, par exemple des gaz de métaux carbonyles ou de composés métalliques hydrogénés volatils pouvant se décomposer en touchant le verre chaud, par exemple les silanes, et notamment le monosilane.

Par le brevet FR 2 314 152, on connaît une buse de ce type dans laquelle on envoie sur la face à revêtir du ruban de verre en cours de déplacement, un gaz de revêtement émis par un distributeur qui s'étend transversalement au ruban et à la direction de mouvement de ce dernier, de façon que le gaz s'écoule parallèlement à la surface du verre, en régime laminaire et avec un débit uniforme sur toute la largeur du ruban.

A cet effet, la buse comprend un dispositif d'injection du gaz, un bloc profilé central, un talon profilé latéral amont et un talon profilé latéral aval disposés de part et d'autre du bloc central, de manière à offrir au gaz arrivant du dispositif d'injection un trajet d'écoulement le long d'un canal de guidage en U qui s'étend entre le talon latéral amont et le bloc central, entre la face inférieure du bloc central et le ruban de verre, et entre le bloc central et le talon aval et un dispositif d'aspiration du gaz ménagé à la sortie du canal entre le bloc central et le talon aval.

Les termes amont, central et aval se réfèrent au sens de mouvement du ruban de verre.

Le talon amont et le talon aval sont pourvus de faces inférieures plates qui s'étendent parallèlement à la surface du verre et à faible distance de cette surface (environ 1 mm), afin de minimiser les fuites de gaz apparaissant entre ces faces et le verre.

Cette buse fonctionne correctement lorsqu'on veut déposer sur le ruban de verre un revêtement de faible épaisseur, par exemple inférieur à 60 nanomètres et/ou mettant en jeu des débits faibles de gaz, par exemple de l'ordre de 100 l/mn sur une buse d'environ 3,30 m de large. En effet, pour ces épaisseurs, le courant gazeux se trouvant dans la partie horizontale du canal s'écoule à une vitesse inférieure à celle du ruban. Ce courant est, de ce fait, entièrement entraîné par le ruban de verre vers l'aval, de sorte qu'il ne se produit aucune fuite de gaz ni d'encrassement sur le talon amont. De même, les fuites pouvant se produire sous le talon aval sont suffisamment faibles, pour que les périodes de production soient longues par rapport aux périodes de nettoyage. La perte de verre est donc relativement limitée.

Par contre, lorsqu'on veut déposer sur le verre un revêtement plus épais, par exemple de silice de l'ordre de 80 nanomètres, et/ou mettant en jeu des débits gazeux plus importants, par exemple de l'ordre de 400 l/mn au moins sur une buse d'environ 3,30 m de large, la vitesse de passage du gaz peut devenir nettement supérieure à celle du ruban de verre. Mais cette augmentation de la vitesse entraîne les inconvénients suivants :
■ la longueur de la partie horizontale du canal de section en U doit être allongée dans la même proportion que les vitesses, afin que le temps de contact du gaz avec le verre soit suffisant d'une part, pour assurer sa décomposition et, d'autre part, pour obtenir l'épaisseur de couche souhaitée,
■ la vitesse du gaz étant supérieure à celle du ruban de verre, les fuites sous le talon aval deviennent importantes et des fuites sous le talon amont apparaissent. Les gaz qui s'échappent ainsi en amont du talon amont et/ou en aval du talon risquent alors, par thermophorèse, de se transformer en particules qui retombent sur le ruban de verre et sont entraînées par lui avant d'y être emprisonnées après dépôt effectif de la couche dans la zone de dépôt, phénomène générateur de 〈〈 voile 〉〉 particulièrement gênant pour la qualité optique du produit final, quel que soit le nombre de couches dont il est revêtu ultérieurement. Les faces inférieures de ces talons s'encrassent rapidement par dépôt de matière de revêtement, ce qui crée des veines gazeuses où les vitesses d'écoulement sont plus fortes, et se traduit par un dépôt non homogène dans le sens transversal du ruban de verre. Celui-ci se trouve alors recouvert d'une couche de matière dont l'épaisseur, donc la couleur, la réflexion lumineuse et la transmission lumineuse, varient transversalement,

. lorsque l'encrassement devient trop important, des particules de revêtement peuvent toucher le verre et y laisser des marques,
. le dépôt qui s'accroît au cours du temps nécessite un nettoyage périodique de la buse, entraînant de ce fait une perte de verre, puisque l'installation de production continue à débiter pendant le nettoyage,
. les fuites de gaz non récupérées polluent l'atmosphère du bain de flottage du verre dans la mesure où une telle buse est installée à l'intérieur d'une enceinte float pour la fabrication du verre.

La présente invention vise à remédier à tous ces inconvénients en proposant une buse capable de déposer sur le ruban de verre une couche de revêtement relativement épaisse et/ou mettant en jeu des débits élevés de gaz.

L'invention a pour objet l'ensemble d'une buse pour la formation d'une couche de revêtement sur du verre et d'un ruban de verre se déplacant à vitesse constante sur un bain de flottage par pyrolyse d'un mélange gazeux a régime d'écoulement laminaire. Ladite buse s'étend, en position de fonctionnement, sur toute la largeur du ruban de verre et comprend un système d'injection de gaz, un bloc profilé central, un talon profilé amont et un talon profilé aval disposés de part et d'autre au bloc central de manière à offrir du gaz arrivant du dispositif d'injection, un trajet d'écoulement le long du canal de guidage en U qui s'étend entre le talon amont et le bloc central, entre la face inférieure du bloc central et le ruban de verre et entre le bloc central et le talon aval. Le talon aval est surélevé par rapport au ruban de verre comparativement au bloc central, de manière à ce que la distance séparant la face inférieure du talon aval de la surface du ruban de verre soit comprise entre 10 et 50 mm. En outre, la distance séparant la face inférieure du bloc central de la surface du ruban de verre est choisie entre 3 et 6 mm, et on munit la buse d'un premier dispositif d'aspiration ménagé à la sortie du canal entre le bloc central et le talon aval et de seconds moyens d'aspiration disposés en amont du talon amont ou en aval du talon aval.

La buse selon l'invention se caractérise donc en ce que le talon aval est surélevé par rapport au ruban de verre comparativement au bloc central, de manière à ce que la distance séparant la face inférieure dudit talon aval du ruban de verre soit d'au moins 10 millimètres, notamment entre 10 et 50 millimètres et de préférence entre 10 et 30 millimètres.

Bien qu'en surélevant le talon aval on fasse apparaître sous ce dernier un passage de section importante, on Bien qu'en surélevant le talon aval on fasse apparaître sous ce dernier un passage de section importante, on constate qu'il ne se produit pratiquement pas de fuite sous ce talon, car en raison de la dépression qui est créée par l'aspiration, il apparaît un contre-courant de gaz ambiant qui est aspiré en même temps que le courant gazeux qui a longé le ruban de verre. Ce contre-courant s'écoule sur le ruban de verre, en sens inverse du courant de gaz de revêtement et empêche donc ce dernier de s'échapper sous le talon aval.

De plus, la face inférieure du talon aval étant surélevée, on comprend que son éventuel encrassement n'entraîne que peu ou pas de perturbation de l'écoulement du gaz et ne risque pas de laisser des marques sur le verre.

En outre, les effluents gazeux sont entièrement aspirés et ne risquent pas de polluer l'atmosphère du bain de flottage.

Toutefois, du gaz de revêtement peut encore s'échapper sous le talon amont. Bien que le débit de fuite soit très faible à ce niveau, puisque le gaz s'écoule principalement dans le même sens que le ruban de verre, les fuites peuvent modifier, à la longue, la composition de l'atmosphère du bain de flottage.

Pour éviter cet inconvénient, la buse selon l'invention est avantageusement munie de seconds moyens d'aspiration disposés en amont du talon amont. On peut, éventuellement, également prévoir ce type de seconds moyens d'aspiration en aval du talon aval.

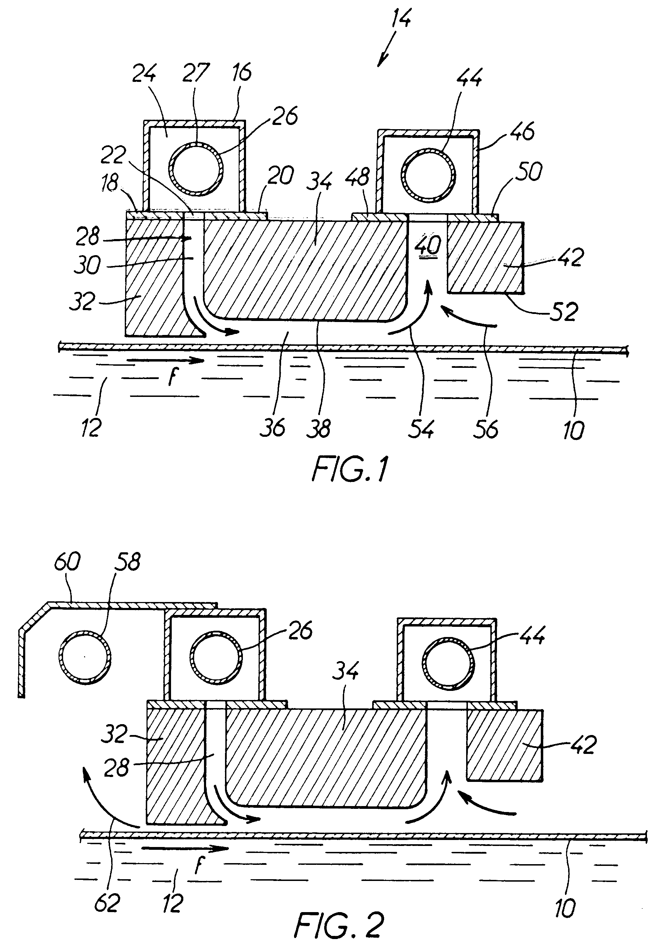

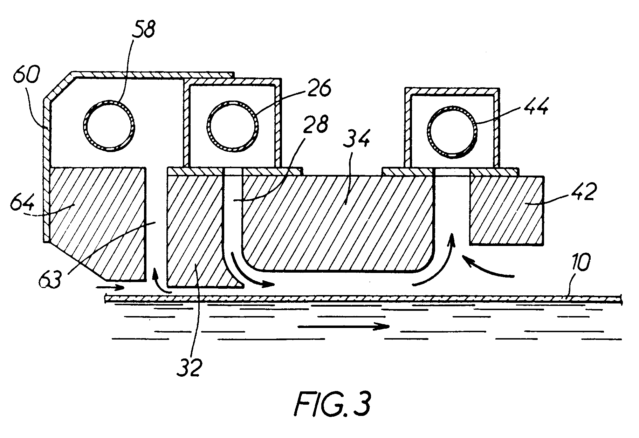

L'invention sera décrite à présent en détail en regard des dessins annexés dans lesquels :
■ la figure 1 est une vue, en coupe transversale, d'une buse selon l'invention,
■ la figure 2 montre la buse de la figure 1 munie de moyens d'aspiration supplémentaires,
■ la figure 3 montre la buse de la figure 1 munie de moyens d'aspiration supplémentaires.

Pour une description détaillée d'une buse classique, on se reportera, par exemple, au brevet mentionné précédemment. Dans ce qui suit, on ne décrira que les éléments de la buse qui sont strictement nécessaires à la compréhension de l'invention.

La figure 1 montre un ruban de verre 10 surnageant à la surface d'un bain de métal 12, habituellement formé d'étain en fusion à l'intérieur d'une enceinte, non représentée, contenant le bain d'étain. Le verre se déverse sur le bain à partir d'un four de fusion de verre, non représenté, situé à gauche de la figure 1, s'y étale jusqu'à former un ruban, lequel est extrait du bain à une vitesse constante dans le sens de la flèche f par des moyens extracteurs montés à la sortie du bain, du côté droit de la figure.

Au-dessus du ruban de verre 10, dans une zone du bain float où il a acquis une stabilité dimensionnelle, est montée une buse 14 pour l'amenée de gaz de revêtement. La buse est disposée transversalement au ruban de verre et elle s'étend sur toute la largeur de ce dernier. Elle comprend un profilé 16, de section en U retourné, dont les bords des parois sont fixés sur des consoles horizontales 18, 20. Celles-ci définissent entre elles une ouverture oblongue 22 transversale par rapport au ruban et ayant une longueur égale à la largeur du ruban.

Dans la chambre 24, définie par le profilé, est logé un conduit d'amenée de gaz 26 percé sur toute sa longueur de trous 27. Le gaz s'étend dans la chambre 24 où il se met à une pression uniforme et s'écoule à travers l'ouverture 22 vers un canal 28 de section en U. Ce canal comprend une chambre verticale d'injection 30 définie entre un talon profilé amont 32 et un bloc profilé central 34, une chambre horizontale 36, d'épaisseur constante, comprise entre le ruban de verre 10 et la face inférieure 38 du bloc central qui est plate et une chambre verticale d'aspiration 40 définie entre le bloc central et un talon profilé aval 42.

A la sortie de la chambre 40, le gaz est aspiré par un conduit d'aspiration transversal 44 logé dans un profilé 46 de section en U retourné, fixé sur le bloc central et sur le talon amont par l'intermédiaire de consoles 48, 50.

De façon connue en soi, le talon amont 32 est pourvu d'une face inférieure plate positionnée parallèlement au ruban de verre et à une distance aussi petite que possible de ce dernier, par exemple à 1 mm, afin de limiter au maximum les fuites de gaz sous ledit talon vers l'amont.

La hauteur de la chambre horizontale 36 est plus importante (3 à 6 mm) afin de permettre au courant gazeux, arrivant de la chambre d'injection 30, de s'écouler selon un régime laminaire, uniformément sur toute la longueur du ruban de verre.

Selon l'invention, pour éviter que l'éventuel encrassement de la face inférieure 52 du talon aval 42 ne soit perturbant, celle-ci est écartée du ruban de verre, à une distance d'au moins 10 mm, par exemple entre 10 et 50 mm et, de préférence, entre 10 et 30 mm et même entre 10 et 20 mm. Malgré cela, il ne se produit aucune fuite sous le talon aval car le courant gazeux 54 sortant de la chambre horizontale 36 est bloqué par un contre-courant 56 de gaz ambiant du bain qui est aspiré par le conduit d'aspiration 44 en même temps que ledit courant gazeux.

Dans les modes de réalisation des figures 2 et 3, il est prévu un deuxième conduit d'aspiration 58 monté en amont du talon amont 52, pour aspirer les fuites de gaz 62 se produisant sous ce dernier. On évite ainsi toute pollution de l'atmosphère du bain de flottage, même quand les quantités de gaz réactifs sont importantes.

La figure 2 montre un premier mode de réalisation de cette aspiration complémentaire. Le conduit 58 est monté à l'intérieur d'un hotte dont la paroi 60 est suffisamment distante du ruban de verre 10 pour que ne se crée pas une vitesse trop élevée du courant chaud d'atmosphère extérieure du fait de l'aspiration. Ce courant chaud risquerait alors, du fait qu'il se place au-dessus des effluents sortant de la buse, d'entraîner leur décomposition par thermophorèse, ce qui se traduirait par l'apparition de défauts sur le verre dus aux retombées sur celui-ci de particules de décomposition. Pour éviter ce phénomène de thermophorèse, générateur de "voile", une hauteur de plusieurs centimètres, par exemple 5 cm, est réservée entre la paroi de hotte 60 et le ruban de verre.

Selon une autre variante montrée figure 3, l'aspiration du conduit 58 s'effectue dans un canal 63 sensiblement parallèle au canal 28, s'étendant en travers du ruban de verre 10 sur toute la longueur de la buse, disposé en amont du talon amont 32 et séparé de l'atmosphère ambiante, notamment celle du float par un talon supplémentaire amont 64 espacé du ruban de verre d'une hauteur plus grande que celle disponible sous le talon amont 32, à savoir de l'ordre de 2 à 10 mm et, de préférence, de l'ordre de 3 à 8 mm.

Ainsi, l'éventuel courant de gaz réactif fuyant sous le talon amont 32 est bloqué par le courant d'atmosphère extérieure aspirée sous ce talon supplémentaire 64, sans entraîner de thermophorèse.

De telles buses sont particulièrement efficaces et peuvent être installées à l'intérieur de l'enceinte d'un bain float de fabrication du verre, mais elles peuvent aussi être mises en place hors float.

En conclusion, le fait de surélever le talon aval éventuellement en proposant des moyens additionnels d'aspiration, notamment en amont du talon aval, autorise des débits de gaz réactifs élevés, en évitant cependant toute fuite intempestive des gaz hors de la zone de dépôt, ce qui supprime les risques de "voile" sur le produit final et de pollution de l'atmosphère de l'enceinte de flottage.

## Revendications

1. Ensemble d'une buse pour la formation d'une couche de revêtement sur du verre et d'un ruban de verre (10) se déplacant à vitesse constante sur un bain de flottage (12), par pyrolyse d'un mélange gazeux à régime laminaire, ladite buse s'étendant en position de fonctionnement sur toute la largeur du ruban de verre et comprenant un dispositif d'injection du gaz (26), un bloc profilé central
(34), un talon profilé amont (32) et un talon profilé aval (42) disposés de part et d'autre du bloc central de manière à offrir au gaz arrivant du dispositif d'injection un trajet d'écoulement le long d'un canal de guidage (28) en U qui s'étend entre le talon amont et le bloc central, entre la face inférieure (38) du bloc central et le ruban de verre et entre le bloc central et le talon aval (42), et un dispositif d'aspiration du gaz (44) ménagé à la sortie du canal (28) entre le bloc central et le talon aval, le talon aval (42) de la buse étant surélevé par rapport au ruban de verre (10) comparativement au bloc central (34), caractérisé en ce que la distance séparant la face inférieure (52) du talon aval (42) de la surface du ruban de verre (10) est comprise entre 10 et 50 mm, en ce que la distance séparant la face inférieure (38) du bloc central (34) de la surface du ruban de verre (10) est comprise entre 3 et 6 mm, et en ce que la buse est munie d'un premier dispositif d'aspiration du gaz (44) ménagé à la sortie du canal (28) entre le bloc central (34) et le talon aval (42) et de seconds moyens d'aspiration (58) disposés en amont du talon amont (32) ou en aval du talon aval (42).

2. Ensemble selon la revendication 1, caractérisé en ce que la distance séparant la face inférieure (32) du talon aval (42) de la surface du ruban de verre (10) entre 10 et 30 mm, notamment entre 10 et 20 mm.

3. Ensemble selon l'une des revendications 1 ou 2, caractérisé en ce que les seconds moyens d'aspiration (58) sont compris à l'intérieur d'une hotte (60) distante du ruban de verre (10) d'une distance qui limite la vitesse des courants de gaz aspirés dans l'espace entre hotte (60) et verre (10).

4. Ensemble selon la revendication 3, caractérisé en ce que la partie basse de la hotte est à une distance du ruban de verre (10) de l'ordre de 5 cm.

5. Ensemble selon l'une des revendications 1 ou 2, caractérisé en ce que les seconds moyens d'aspiration (58) en amont du talon amont (32) agissent par un canal (63) s'étendant sur la longueur de la buse, et qui est limité du côté amont par un talon supplémentaire amont (64).

6. Ensemble selon la revendication 5, caractérisé en ce que le talon supplémentaire amont (64) est séparé du ruban de verre (10) d'une distance de l'ordre de 2 à 10 mm, notamment de l'ordre de 3 à 8 mm.

## Claims

1. Assembly of a nozzle for forming a coating film on glass and of a glass band (10) moving at constant velocity over a float bath (12), by pyrolysis of a gaseous mixture in laminar flow, said nozzle extending, in the operating position, across the entire width of the glass band and comprising an injection device for the gas (26), a central profiled block (34), an upstream profiled heel (32) and a downstream profiled heel (42), these heels being disposed on either side of the central block in such a way as to offer, to the gas arriving from the injection device, a flow path along a guidance channel (28) of U-section which extends between the upstream heel and the central block, between the lower face (38) of the central block and the glass band, and between the central block and the downstream heel (42), and a suction or exhaust device for the gas (44), arranged at the outlet from the channel (28) between the central block and the downstream heel, the downstream heel (42) of the nozzle being raised relative to the glass band (10) by comparison with the central block (34), characterized in that the distance separating the lower face (52) of the downstream heel (42) from the surface of the glass band (10) lies between 10 and 50 mm, in that the distance separating the lower face (38) of the central block (34) from the surface of the glass band (10) lies between 3 and 6 mm, and in that the nozzle is provided with a first suction device for the gas (44) arranged at the outlet from the channel (28) between the central block (34) and the downstream heel (42) and with second suction means (58) disposed upstream of the upstream heel (32) or downstream of the downstream heel (42).

2. Assembly according to Claim 1, characterized in that the distance separating the lower face (32) of the downstream heel (42) from the surface of the glass band (10) lies between 10 and 30 mm, notably between 10 and 20 mm.

3. Assembly according to one of Claims 1 or 2, characterized in that the second suction means (58) are contained inside a hood (60), spaced from the glass band (10) by a distance which limits the velocity of the gas currents sucked into the space between hood (60) and glass (10).

4. Assembly according to Claim 3, characterized in that the lower part of the hood is at a distance from the glass band (10) of the order of 5 cm.

5. Assembly according to one of Claims 1 or 2, characterized in that the second suction means (58) upstream of the upstream heel (32) act through a channel (63) extending along the length of the nozzle, which channel is bounded on the upstream side by a supplementary upstream heel (64).

6. Assembly according to Claim 5, characterized in that the supplementary upstream heel (64) is separated from the glass band (10) by a distance of the order of 2 to 10 mm, notably of the order of 3 to 8 mm.

## Patentansprüche

1. Düsenaufbau zur Herstellung einer Überzugsschicht durch Pyrolyse eines Gasgemisches, dessen Strömung laminar geführt ist, auf Glas und einem Glasband (10), das mit gleichbleibender Geschwindigkeit auf einem Floatbad (12) durchläuft, wobei sich die Düse in Arbeitsstellung über die gesamte Breite des Glasbandes erstreckt und eine Einblaseinrichtung (26) für das Gas, einen stromlinienförmigen zentralen Block (34), einen stromlinienförmigen, in Durchlaufrichtung des Glasbandes hinteren Vorsatz (32) und einen stromlinienförmigen vorderen Vorsatz (42), die derart an beiden Seiten des zentralen Blocks angeordnet sind, daß dem von der Einblaseinrichtung kommenden Gas ein Strömungsweg entlang eines U-förmigen Führungskanals (28) geschaffen wird, der zwischen dem hinteren Vorsatz und dem zentralen Block, der Unterseite (38) des zentralen Blocks und dem Glasband und dem zentralen Block und dem vorderen Vorsatz (42) verläuft, und eine Absaugeinrichtung (44) für das Gas umfaßt, die am Ausgang des Kanals (28) zwischen dem zentralen Block und dem vorderen Vorsatz angebracht ist, wobei der vordere Vorsatz (42) der Düse in bezug auf den zentralen Block (34) gegenüber dem Glasband (10) erhöht ist, **dadurch gekennzeichnet, daß** der Abstand zwischen der Unterseite (52) des vorderen Vorsatzes (42) und der Oberfläche des Glasbandes (10) 10 bis 50 mm beträgt, **daß** der Abstand zwischen der Unterseite (38) des zentralen Blocks (34) und der Oberfläche des Glasbandes (10) zwischen 3 und 6 mm beträgt **und daß** die Düse mit einer ersten Absaugeinrichtung (44) für das Gas, die am Ausgang des Kanals (28) zwischen dem zentralen Block (34) und dem vorderen Vorsatz (42) angebracht ist, und mit zweiten Absaugmitteln (58), die hinter dem hinteren Vorsatz (32) oder vor dem vorderen Vorsatz (42) angeordnet sind, ausgerüstet ist.

2. Aufbau nach Anspruch 1, **dadurch gekennzeichnet, daß** der Abstand, der die Unterseite (32) des vorderen Vorsatzes (42) von der Oberfläche des Glasbandes (10) trennt, zwischen 10 und 30 und insbesondere zwischen 10 und 20 mm beträgt.

3. Aufbau nach Anspruch 1 oder 2, **dadurch gekennzeichnet, daß** die zweiten Absaugmittel (58) im Inneren einer Abzugshaube (60) enthalten sind, die sich zum Glasband (10) in einer Entfernung befindet, welche die Geschwindigkeit der in den Zwischenraum zwischen der Abzugshaube (60) und dem Glasband (10) angesaugten Gasströme begrenzt.

4. Aufbau nach Anspruch 3, **dadurch gekennzeichnet, daß** sich der untere Teil der Abzugshaube in einer Entfernung von etwa 5 cm zum Glasband (10) befindet.

5. Aufbau nach Anspruch 1 oder 2, **dadurch gekennzeichnet, daß** die zweiten Absaugmittel (58) hinter dem hinteren Vorsatz (32) durch einen sich über die Länge der Düse erstreckenden Kanal (63) wirken, der an der hinteren Seite von einem zusätzlichen hinteren Vorsatz (64) begrenzt wird.

6. Aufbau nach Anspruch 5, **dadurch gekennzeichnet, daß** der Abstand zwischen dem zusätzlichen hinteren Vorsatz (64) und dem Glasband (10) etwa 2 bis 10 und insbesondere etwa 3 bis 8 mm beträgt.
